# EUROPEAN PATENT SPECIFICATION

(11) **EP 1 020 254 B1**
(45) Date of publication and mention of the grant of the patent: **10.12.2003**
(21) Application number: 99933146.5
(22) Date of filing: 29.07.1999
(51) Int. Cl.: B24B 37/04, B24B 41/047, B24D 9/08

(54) **POLISHING METHOD AND POLISHING DEVICE**
POLIERVERFAHREN UND VORRICHTUNG
PROCEDE ET DISPOSITIF DE POLISSAGE

(30) Priority: 04.08.1998 JP 22057398
(43) Date of publication of application: 19.07.2000
(73) Proprietor: Shin-Etsu Handotai Co., Ltd, Tokyo 100-0005 (JP)
(72) Inventor: OKAMURA, Kouichi, Naoetsu Electronics Co., Ltd., Nakakubiki-gun, Niigata 942-0157 (JP); SUZUKI, Fumio, Shin-Etsu Handotai Co., Ltd, Nishishirakawa-gun, Fukushima 961-8061 (JP); MASUMURA, Hisashi, Shin-Etsu Handotai Co., Ltd., Nishishirakawa-gun, Fukushima 961-8061 (JP)
(74) Representative: Rackham, Stephen Neil
(86) International application number: PCT/JP99/04062
(87) International publication number: WO 00/007771

(56) References cited:
- EP-A- 0 845 328
- JP-A- 5 237 761
- JP-U- 61 175 352

## Description

The present invention relates to a polishing method and a polishing apparatus, as per the preamble of claims 1 and 8. EP-A-0845328 discloses one such polishing method and apparatus.

When a work is polished, generally, the polishing is carried out by pressing the work against a polishing pad adhered to a turn table while polishing slurry is flowed on the polishing pad and by rotating the work and the turn table.

A polishing apparatus used for polishing has a turn table to which a polishing pad is adhered, a polishing slurry supplying means for supplying polishing slurry to the polishing pad, and a rotating means for rotating a work and the turn table.

Recently, for improving productivity, concretely, for reducing a time of apparatus stop when polishing pads are exchanged, a polishing apparatus in which a turn table is detachable has been proposed. With such a system the turn table is supported on a turn table receiving member. With a polishing apparatus, casting, stainless steel and ceramic having high strength are used for materials of the turn table and the turn table receiving member for heightening hardness of the polishing apparatus. During polishing with polishing apparatus, the turn table receives a polishing load from the work, while the turn table receives a reaction force from the turn table receiving member. The reaction force becomes contact pressure between the polishing pad and the work.

It has been proposed that grooves are formed in a turn table support surface of the turn table receiving member for easily detaching the turn table from the turn table receiving member by introducing a fluid, for example water. In this case, if grooves are formed in the turn table receiving member, thereby the turn table receives the reaction force from non-groove portions of the turn table receiving member, but does not receive the reaction force from grooved portions. As a result, the contact pressure between the polishing pad and the work becomes non-uniform within a surface of the work, thereby a polishing rate of the work becomes non-uniform within the surface to form minute waviness on the work surface.

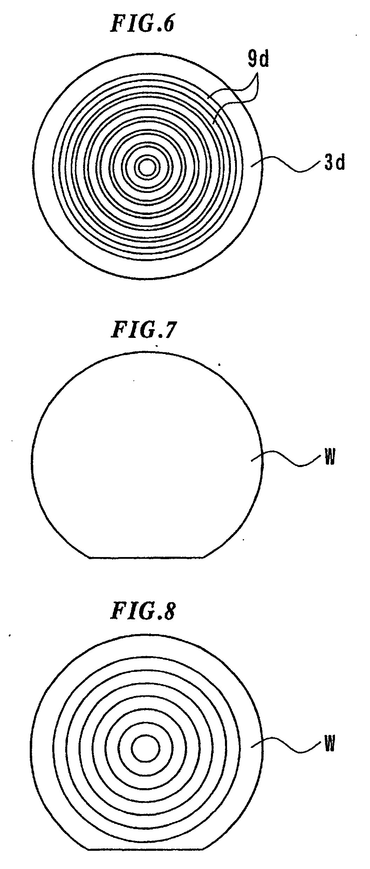

As shown in FIG. 6, for example, in a case that concentric circle-like grooves 9d are provided in a turn table receiving member 3d and that a rotation center of the turn table receiving member 3d and a rotation center of a work coincide with each other, strong portions and weak portions of contact pressure against a polishing pad generate concentrically and alternately about the rotation center of the work. In this case, the polishing rate of the work changes according to the contact pressure. Thus, with the work, portions corresponding to the non-groove portions are more polished, while portions corresponding to the grooved portions are less polished, thereby, as shown in FIG, 8, concentric circle-like waviness is formed on the work W. That is, for example, irregularities of about not more than 0.1 µm are formed periodically on the work. Such a phenomenon is observed when a pattern of the grooves 9d of the turn table receiving member 3d is concentric circle-like or spiral.

Further, even if the rotation center of the turn table receiving member and the rotation center of the work do not coincide with each other, that is, the rotation center of the work is eccentric from the rotation center of the turn table receiving member, when concentric circle-like grooves are provided in the turn table receiving member, the contact pressure to the polishing pad in the vicinity of the rotation center of the work becomes either constantly strong or constantly weak, thereby there is a problem that a polishing degree is changed between a central portion of the work and a peripheral portion thereof.

The present invention was developed in view of the above-described problems. An object of the present invention is to provide a polishing method and a polishing apparatus for making contact pressure between a work and a polishing pad substantially uniform with surfaces to obtain a work having good quality.

According to the first aspect of the present invention, a polishing method is provided having the features of claim 1.

According to the polishing method, the plurality of grooves extending in a generally straight direction are provided in the turn table receiving member, thereby loci of the grooves in the turn table receiving member against respective portions of the rotating work show complex loci, so that the contact pressure between the polishing pad and the work is substantially averaged. Thus, the contact pressure within the surface of the work from the polishing pad is also averaged, thereby a work can be obtained that has good quality.

According to the second aspect of the present invention, a polishing apparatus is provided having the features of claim 8.

According to the polishing apparatus, a plurality of grooves are provided in the turn table receiving member extending in a generally straight direction, thereby loci of the grooves in the turn table receiving member against respective portions of the rotating work show complex loci . As a result, the contact pressure of the turn table receiving member is substantially averaged. Thus, the contact pressure within the surface of the work from the polishing pad is also averaged, thereby a work can be obtained that has good quality.

With the polishing method and the polishing apparatus, the grooves can be provided in parallel with each other. The grooves can have a grid-like or radial configuration. It is preferable that a rotation center of the turn table receiving member and a rotation center of the work are different from each other. Thereby, the contact pressure between the polishing pad and the work is substantially averaged.

The work can include a semiconductor wafer. In a case of a work, such as a semiconductor wafer that is extremely thin and requires extremely high flatness, an effect obtained by applying the method or the apparatus according to the present invention is particularly remarkable. It is preferable that a plurality of grooves are provided as the groove and that widths of the grooves are within 3 to 15 mm, spacings of the grooves are within 10 to 100 mm and depths of the grooves are within 1 to 10 mm, respectively. Particularly, when a semiconductor wafer is polished with the present invention, good flatness can be obtained when the grooves are within the ranges, further, detachment of the turn table from the turn table receiving member becomes easy.

### Brief Description of Drawings

FIG. 1 is a schematic structural view of a polishing apparatus relating to the first embodiment of the present invention;
FIG. 2 is a plan view of a turn table receiving member of the polishing apparatus relating to the first embodiment;
FIG. 3 is a plan view of a turn table receiving member of another polishing apparatus relating to the second embodiment of the present invention;
FIG. 4 is a plan view of a turn table receiving member of another polishing apparatus relating to the third embodiment of the present invention;
FIG. 5 is a view for explaining a suitable groove pattern of the turn table receiving member of FIG. 4;
FIG. 6 is a plan view of a turn table receiving member of the polishing apparatus according to the preceding developed art;
FIG. 7 is a view showing a polished surface of a work when the work is polished with the turn table receiving member of FIG. 2; and
FIG. 8 is a view showing a polished surface of a work when the work is polished with the turn table receiving member of FIG. 6.

### Preferred Embodiment of the Invention

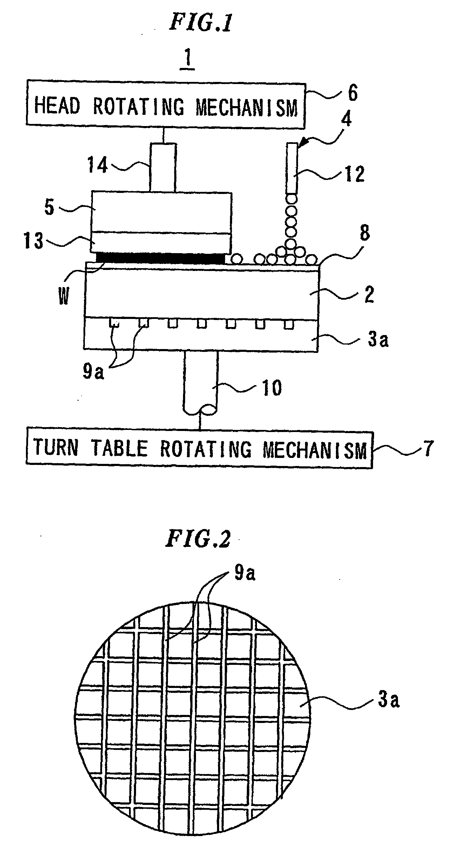

FIG. 1 is a schematic view of a polishing apparatus relating to the first embodiment of the present invention. The polishing apparatus 1 has a turn table 2 , a turn table receiving member 3, a polishing slurry supplying unit 4, a top ring 5, a head rotating mechanism 6 and a turn table rotating mechanism 7.

To the turn table 2, a polishing pad 8 is adhered. The turn table 2 is supported attachably and detachably by the turn table receiving member 3a. The reason for constituting attachably and detachably is to make exchange for the polishing pad 8 easy by detaching integrally the turn table 2 and the polishing pad 8 in exchanging the polishing pad 8 . In this case, mounting of the turn table 2 to the turn table receiving member 3a is carried out with an exclusive jig.

As shown in FIG. 2, grid-like grooves 9a are provided in an upper surface of the turn table receiving member 3a. The grooves 9a in this case may be wavy lines, if these are provided in a grid as a whole. The grooves 9a are formed in the surface of the turn table receiving member 3a for supplying the grooves 9a with fluid, for example, water in detaching the turn table 2 from the turn table receiving member 3a to easily detach the turn table 2 by the water pressure. An axis 10 of the turn table receiving member 3a is connected to a motor (not shown) through a reduction gear. The reduction gear and the motor constitute the turn table rotating mechanism 7.

A rotation center of the turn table receiving member 3a is different from a rotation center of a work W. Thereby, contact pressure between the polishing pad 8 and the work W is as substantially averaged as possible.

The polishing slurry supplying unit 4 is provided with a nozzle 12 connected with a polishing slurry store tank (not shown). The polishing slurry is supplied to a rubbing portion between the work W and the polishing pad 8 from the nozzle 12.

The top ring 5 is for pressing the work W against the polishing pad 8, however, not to directly press it, but to press it through a plate 13. In this case, the work W is adhered to the plate 13 with a wax method or a waxless method. An axis 14 of the top ring 5 is connected to a motor (not shown) through a reduction gear. The reduction gear and the motor constitute the head rotating mechanism 6.

Next, a polishing method of the work W by the polishing apparatus 1 will be explained.

At first, the plate 13 to which the work W is adhered is placed at an under side of the top ring 5 to bring the work W into contact with the polishing pad 8. Then, the top ring 5 is lowered to press the work W against the polishing pad 8 through the plate 13. While driving the head rotating mechanism 6 and the turn table rotating mechanism 7, the polishing slurry is supplied from the nozzle 12 of the polishing slurry supplying unit 4 to polish the work W. After the polishing is completed, the top ring 5 is raised and the plate 13 is taken out.

According to the polishing apparatus 1 and the polishing method carried out by the polishing apparatus 1, a following effect can be obtained.

That is, the grooves 9a are provided in the turn table receiving member 3a, thereby when the work W is pressed against the polishing pad 8, the reaction forces that the turn table 2 is received from the grooved portions and the non-groove portions of the turn table receiving member 3a are different. However, the grooves 9a are grid-like, so that transferred portions from the grooved portions and the non-groove portions of the turn table receiving member 3a to the turn table 2 are uniformly contacted each portion of the rotating work W through the polishing pad 8. Thus, the contact pressure within the surface of the work W against the turn table 2 is averaged, so that no deviated load acts on the work W, thereby good quality can be obtained.

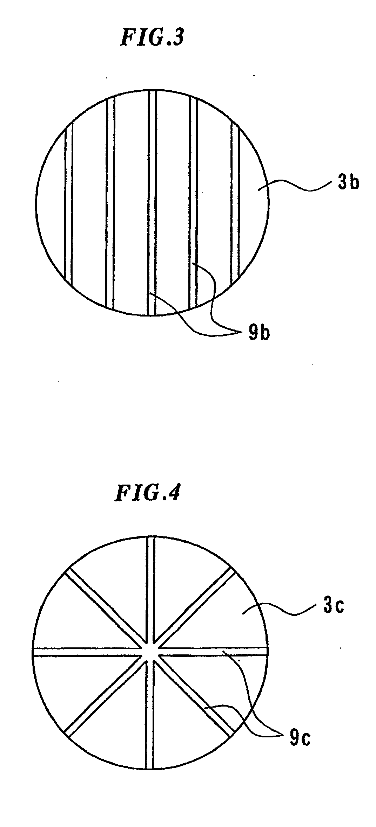

FIG. 3 shows a turn table receiving member 3b of a polishing apparatus relating to the second embodiment, where straight line-like grooves 9b are formed in parallel. In this case, if the grooves 9b are provided in a straight line direction as a whole, the grooves 9b may be wavy lines. Spacings between the grooves and the number of the grooves are not especially limited, however, for detaching the turn table 2, it is preferable that not less than 3 straight line-like grooves are formed in approximately the same spacings and parallel over the whole turn table.

According to the polishing apparatus, the same effect as of the polishing apparatus 1 according to the first embodiment can be obtained.

FIG. 4 shows a turn table receiving member 3c of a polishing apparatus relating to the third embodiment, where radial grooves 9c are provided. The grooves 9c in this case may be wavy lines if it is provided radially as a whole.

According to the polishing apparatus, the same effect as of the polishing apparatus 1 according to the first embodiment can be obtained.

Next, a preferable pattern of the grooves in the turn table receiving member will be explained.

### 1. Widths of the grooves: 3 mm to 15 mm

The turn table does not receive the stress from the grooved portions of the turn table receiving member, and the turn table receives the stress only from the non-groove portions. The difference of the stress received by the turn table causes formation of the waviness in the surface of the turn table . In this case, if the widths of the grooves exceed 15 mm, waviness having large wavelength is formed in the surface of the turn table, which influences the flatness . On the other hand, when it is less than 3 mm, even if the water is supplied to the grooves in the turn table receiving member in detaching the turn table, required pressure can not be obtained, so that it is difficult to detach the turn table from the turn table receiving member.

### 2. Spacings between the grooves: 10 mm to 100 mm

If the spacings between the grooves exceed 100 mm, the detachment of the turn table becomes difficult . On the other hand, if it is below 10 mm, the surface of the turn table waves finely and largely to influence the flatness.

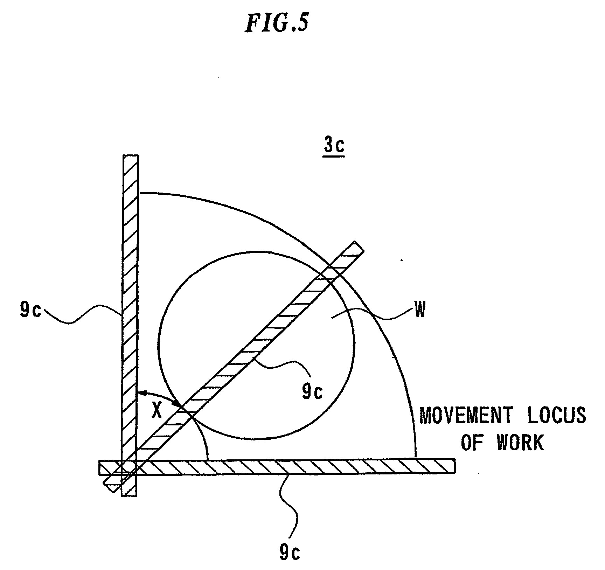

When the grooves in the turn table receiving member 3c are provided radially, it is preferable that the rotation center of the turn table receiving member 3c and furthermore of the turn table and the rotation center of the work are different, besides the work is polished at the eccentric position of the turn table. In this case, as shown in FIG. 5, it is preferable that a circular arc length X between the most inner portion of a movement locus of the work W to the turn table receiving member 3c (precisely, the polishing pad 8) and an intersection of two adjacent grooves 9c is at least 10 mm.

### 3. Depths of the grooves: 1 mm to 10 mm

If the depths of the grooves exceed 10 mm, the hardness of the turn table receiving member lowers to influence the flatness. On the other hand, if it is below 1 mm, it is difficult to supply the grooves in the turn table receiving member with the water in detaching the turn table and is difficult to detach the turn table.

### (Example of an experiment)

In the experiment, a polishing is carried out by using the turn table receiving member 3a in which the grid-like grooves 9a as shown in FIG. 2 are provided. In addition, for comparing an effect to that, a polishing of a work (an article to be polished) is carried out by using the turn table receiving member 3d in which the concentric circle-like grooves 9d are provided according to the preceding developed art as shown in FIG. 6.

### 1. Conditions

### (1) Article to be polished

In the first example, for the article to be polished, an etched wafer which was a single crystal silicon wafer ( thickness of 735 µm) grown with the Czochralski method and which was a p-type, and had crystal orientation <100> and 200 mmφ was prepared.

### (2) Polishing pad

A polishing pad that was an unwoven cloth type and had hardness 80 (ascar C hardness: conform to JISK6301) was used.

### (3) Polishing slurry

Colloidal silica polishing slurry (pH = 10.5) was used.

### (4) Polishing load

The work was pressed against the polishing pad by the top ring with the polishing load of 250 g/cm².

### (5) Entire polishing stock removal

The amount of removal, that is, the entire polishing stock removal with the polishing was 12 µm.

### (6) Turn table

A turn table made of SiC and having a thickness of 30 mm and a diameter of 700 mmφ was used.

### (7) Turn table receiving member

It was made of ceramic, and widths of grooves were 10 mm, spacings thereof were 30 mm, and depths of the grooves were 3 mm.

### 2. Polishing method

The turn table was attached to the turn table receiving member. With a center of the turn table receiving member and a center of the work 200 mm apart, the work was polished with a single wafer processing. Rotation rates of the work and the turn table were at 40 rpm, respectively. Further, the polishing was carried out with fixing the work while reciprocating the turn table within ± 10 mm.

### 3. Result

When the turn table receiving member 3a in which the grid-like grooves 9a as shown in FIG. 2 were provided was used, as shown in FIG. 7, a specific pattern was not observed on a magic mirror image after the polishing, so that it was confirmed that good quality was obtained. On the other hand, when the turn table receiving member 3d in which the concentric circle-like grooves 9d as shown in FIG. 6 were provided was used, it was confirmed that concentric circle-like patterns, as shown in FIG. 8, were generated on a magic mirror image after the polishing.

The embodiments according to the present invention are explained, however, needless to say, the present invention is not limited to the embodiments, and various modifications may be made within the scope of the claims. For example, in the above-described examples, the polishing of a semiconductor wafer is mainly explained, however, of course the present invention can be applied to a polishing of thin plates, such as glass substrates for liquid crystal panel, quartz glass substrates for photomask, magnetic disc substrates or other substrates other than semiconductor wafers.

### Industrial Applicability

Polishing is carried out by supporting a turn table by a grooved surface of a turn table receiving member, the grooved surface being provided with a groove extending in a straight direction, pressing a work against a polishing pad adhered to the turn table while flowing polishing slurry, and rotating the work and the turn table, thereby a work having good quality can be obtained. Further, exchange of the turn table is easy. Therefore, the polishing method and the polishing apparatus according to the present invention suit particularly the polishing for various thin plate products, such as semiconductor wafers, glass substrates for liquid crystal panel, quartz glass substrates for photomask, magnetic disc substrates or other substrates.

## Claims

1. A polishing method comprising the steps of:
providing a turn table (2);
pressing a work (W) against a polishing pad (8) adhered to the turn table (2) while flowing polishing slurry; and,
carrying out polishing by rotating the work (W) and the turn table (2);
**characterised by** providing a turn table receiving member (3) for supporting the turn table (2), a supporting surface of the turn table receiving member (3) being provided with a plurality of grooves (9) extending in a generally straight direction.

2. A polishing method according to claim 1, wherein the grooves (9) are directed parallel with one another are directed in a grid, or are directed radially.

3. A polishing method according to claim 1 or 2, wherein the grooves (9) are straight or are wavy in configuration.

4. A polishing method according to any one of claims 1 to 3, wherein a rotation center of the turn table receiving member (3) and a rotation center of the work (W) are different from one another.

5. A polishing method according to any one of claims 1 to 4, wherein the widths of the grooves (9) are within a range from 3 to 15 mm, the spacings of the grooves (9) are within a range from 10 to 100 mm and the depths of the grooves are within a range from 1 to 10 mm.

6. A polishing method according to any one of claims 1 to 5, wherein the work is a semiconductor wafer (W).

7. A method according to any one of claims 1 to 6, wherein the turn table (2) is located below the work (W).

8. A polishing apparatus comprising:
a turn table (2) to which a polishing pad (8) is adhered;
a polishing slurry supplying unit (4) for supplying polishing slurry to the polishing pad (8); and,
a rotating mechanism (6,7) for rotating a work (W) and the turn table (2),
**characterised in that** a turn table receiving member (3) supports the turn table (2); and,
**in that** the turn table (2) is supported on a surface of the turn table receiving member (3) which is provided with a plurality of grooves (9) extending in a generally straight direction.

9. A polishing apparatus according to claim 8, wherein the grooves (9) are directed parallel with one another, are directed in a grid, or are directed radially.

10. A polishing apparatus according to claim 8 or 9, wherein the grooves (9) are straight or wavy in configuration.

11. A polishing apparatus as claimed in any one of claims 8 to 10, wherein a rotation center of the turn table receiving member (3) and a rotation center of the work (W) are different from one another.

12. A polishing apparatus as claimed in any one of claims 8 to 11, wherein the widths of the grooves (9) are within a range from 3 to 15 mm, the spacings of the grooves are within a range from 10 to 100 mm, and depths of the grooves are within a range from 1 to 10 mm.

13. A polishing apparatus as claimed in any one of claims 8 to 12, wherein the work (W) is a semiconductor wafer (W).

14. A polishing apparatus according to any one of claims 8 to 13, wherein the turn table (2) is located beneath the work (W).

## Patentansprüche

1. Polierverfahren, das die folgenden Schritte umfasst:
Bereitstellen eines Drehtischs (2);
Pressen eines Werkstücks (W) an eine Polierscheibe (8), die an dem Drehtisch (2) haftet, und gleichzeitiges Zuleiten von Polier-Aufschlämmung; und
Ausführen von Polieren durch Drehen des Werkstücks (W) und des Drehtischs (2);
**gekennzeichnet durch** das Bereitstellen eines Drehtisch-Aufnahmeelementes (3), das den Drehtisch (2) trägt, wobei eine Tragefläche des Drehtisch-Aufnahmeelementes (3) mit einer Vielzahl von Nuten (9) versehen ist, die sich in einer im Allgemeinen geraden Richtung erstrecken.

2. Polierverfahren nach Anspruch 1, wobei die Nuten (9) parallel zueinander ausgerichtet sind, in einem Gitter ausgerichtet sind oder radial ausgerichtet sind.

3. Polierverfahren nach Anspruch 1 oder 2, wobei die Nuten (9) gerade sind oder Wellenform haben.

4. Polierverfahren nach einem der Ansprüche 1 bis 3, wobei ein Drehmittelpunkt des Drehtisch-Aufnahmeelementes (3) und ein Drehmittelpunkt des Werkstücks (W) sich voneinander unterscheiden.

5. Polierverfahren nach einem der Ansprüche 1 bis 4, wobei die Breiten der Nuten (9) in einem Bereich zwischen 3 und 15 mm liegen, die Abstände der Nuten (9) in einem Bereich zwischen 10 und 100 mm liegen und die Tiefen der Nuten in einem Bereich zwischen 1 und 10 mm liegen.

6. Polierverfahren nach einem der Ansprüche 1 bis 5, wobei das Werkstück ein Halbleiter-Wafer (W) ist.

7. Verfahren nach einem der Ansprüche 1 bis 6, wobei sich der Drehtisch (2) unter dem Werkstück (W) befindet.

8. Poliervorrichtung, die umfasst:
einen Drehtisch (2), an dem eine Polierscheibe (8) haftet;
eine Polieraufschlämmung-Zuführeinheit (4), die der Polierscheibe (8) Polieraufschlämmung zuführt; und
einen Drehmechanismus (6, 7), der ein Werkstück (W) und den Drehtisch (2) dreht,
**dadurch gekennzeichnet, dass** ein Drehtisch-Aufnahmeelement (3) den Drehtisch (2) trägt; und
dadurch, dass der Drehtisch (2) von einer Fläche des Drehtisch-Aufnahmeelementes (3) getragen wird, die mit einer Vielzahl von Nuten (9) versehen ist, die sich in einer im Allgemeinen geraden Richtung erstrecken.

9. Poliervorrichtung nach Anspruch 8, wobei die Nuten (9) parallel zueinander ausgerichtet sind, in einem Gitter ausgerichtet sind öder radial ausgerichtet sind.

10. Poliervorrichtung nach Anspruch 8 oder 9, wobei die Nuten (9) gerade sind oder Wellenform haben.

11. Poliervorrichtung nach einem der Ansprüche 8 bis 10, wobei ein Drehmittelpunkt des Drehtisch-Aufnahmeelementes (3) und ein Drehmittelpunkt des Werkstücks (W) sich voneinander unterscheiden.

12. Poliervorrichtung nach einem der Ansprüche 8 bis 11, wobei die Breiten der Nuten (9) in einem Bereich zwischen 3 und 15 mm liegen, die Abstände der Nuten in einem Bereich zwischen 10 und 100 mm liegen und Tiefen der Nuten in einem Bereich zwischen 1 und 10 mm liegen.

13. Poliervorrichtung nach einem der Ansprüche 8 bis 12, wobei das Werkstück (W) ein Halbleiter-Wafer (W) ist.

14. Poliervorrichtung nach einem der Ansprüche 8 bis 13, wobei sich der Drehtisch (3) unter dem Werkstück (W) befindet.

## Revendications

1. Procédé de polissage comprenant les étapes consistant à:
prévoir une plate-forme tournante (2);
appuyer une pièce à traiter (W) contre un tampon à polir (8) collé à la plate-forme tournante (2), tout en faisant s'écouler une pâte de polissage; et,
effectuer le polissage en faisant tourner la pièce à traiter (W) et la plate-forme tournante (2);
**caractérisé en ce qu'**il comprend l'étape consistant à prévoir un organe (3) de réception de la plate-forme tournante, pour supporter la plate-forme tournante (2), une surface de support de l'organe (3) de réception de la plate-forme tournante étant pourvue de multiples rainures (9) s'étendant dans une direction générale droite.

2. Procédé de polissage selon la revendication 1, dans lequel les rainures (9) sont orientées parallèlement l'une à l'autre, sont orientées en une grille, ou sont orientées dans des directions radiales.

3. Procédé de polissage selon la revendication 1 ou 2, dans lequel les rainures (9) sont droites ou de configuration ondulée.

4. Procédé de polissage selon l'une quelconque des revendications 1 à 3, dans lequel un centre de rotation de l'organe (3) de réception de la plate-forme tournante et un centre de rotation de la pièce à traiter (W) sont différents l'un de l'autre.

5. Procédé de polissage selon l'une quelconque des revendications 1 à 4, dans lequel les largeurs des rainures (9) se situent dans une gamme de 3 à 15 mm, les espacements des rainures (9) se situent dans une gamme de 10 à 100 mm, et les profondeurs des rainures se situent dans une gamme de 1 à 10 mm.

6. Procédé de polissage selon l'une quelconque des revendications 1 à 5, dans lequel la pièce à traiter est une tranche de semi-conducteurs (W).

7. Procédé selon l'une quelconque des revendications 1 à 6, dans lequel la plate-forme tournante (2) est située en dessous de la pièce à traiter (W).

8. Dispositif de polissage comprenant:
une plate-forme tournante (2) à laquelle est collé un tampon à polir (8);
une unité (4) d'alimentation en pâte à polir, pour fournir de la pâte à polir au tampon à polir (8); et,
un mécanisme de rotation (6,7) pour faire tourner une pièce à traiter (W) et la plate-forme tournante (2),
**caractérisé en ce qu'**un organe (3) de réception de la plate-forme tournante supporte la plate-forme tournante (2); et,
**en ce que** la plate-forme tournante (2) est supportée sur une surface de l'organe (3) de réception de la plate-forme tournante qui est pourvue de multiples rainures (9) s'étendant dans une direction générale droite.

9. Dispositif de polissage selon la revendication 8, dans lequel les rainures (9) sont orientées parallèlement l'une à l'autre, sont orientées en une grille, ou sont orientées dans des directions radiales.

10. Dispositif de polissage selon la revendication 8 ou 9, dans lequel les rainures (9) sont droites ou de configuration ondulée.

11. Dispositif de polissage tel que revendiqué dans l'une quelconque des revendication 8 à 10, dans lequel un centre de rotation de l'organe (3) de réception de la plate-forme tournante et un centre de rotation de la pièce à traiter (W) sont différents l'un de l'autre.

12. Dispositif de polissage tel que revendiqué dans l'une quelconque des revendication 8 à 11, dans lequel les largeurs des rainures (9) se situent dans une gamme de 3 à 15 mm, les espacements des rainures (9) se situent dans une gamme de 10 à 100 mm, et les profondeurs des rainures se situent dans une gamme de 1 à 10 mm.

13. Dispositif de polissage tel que revendiqué dans l'une quelconque des revendication 8 à 12, dans lequel la pièce à traiter (W) est une tranche de semi-conducteurs (W).

14. Dispositif de polissage selon l'une quelconque des revendication 8 à 13, dans lequel la plate-forme tournante (2) est située en dessous de la pièce à traiter (W).
